# EUROPEAN PATENT APPLICATION

(11) **EP 2 315 239 A1**
(43) Date of publication of application: **27.04.2011**
(21) Application number: 09173972.2
(22) Date of filing: 23.10.2009
(51) Int. Cl.: H01L 21/336

(54) **A method of forming monocrystalline germanium or silicon germanium**

(71) Applicant: IMEC, 3001 Leuven (BE); Katholieke Universiteit Leuven, K.U. Leuven R&D, 3000 Leuven (BE)
(72) Inventor: Vandervorst, Wilfried, B-2800, MECHELEN (BE); Wang, Gang, B-3000, LEUVEN (BE)
(74) Representative: pronovem

(57) **Abstract**

The present invention is related to a method of forming mono-crystalline germanium or silicon germanium in trenches provided in a substrate. In particular, the present invention is directed to an improved method of forming mono-crystalline germanium or silicon germanium fin structures on a semiconducting substrate.

## Description

### Field of the Invention

The present invention is related to the field of germanium or silicon germanium FinFET devices and methods for forming the same.

More specifically, the invention relates to epitaxial growth of mono-crystalline germanium or silicon germanium in (narrow) trenches provided in a substrate. In particular, the present invention is directed to an improved method of forming mono-crystalline germanium or silicon germanium fin structures on a substrate.

### Background of the Invention

Scaling down of planar bulk CMOS devices has become a major challenge in the semiconductor industry. Although device geometrical shrinking already gave a lot of improvements in IC performance, there is still a need for device architectures being introduced beyond the 90 nm technology node.

Multi-gate field effect transistors (MUGFET), also often referred to as fin-based semiconductor devices or FinFETs, is one of the promising candidates for further scaling down to 32 nm or less. Due to their three dimensional architecture, with the gate electrode wrapped around a thin semiconductor fin, improved gate control (and thus less short channel effects) over the channel could be achieved by using multiple gates.

The silicon FinFET has emerged as one of the promising candidates for highly scaled MOSFETs. However, with silicon CMOS devices scaled into deep sub-micrometer regime, new materials with higher channel mobility are needed for enhancing the devices performance.

It is known in the art that germanium MOSFETs have higher effective electron and hole mobility than silicon MOSFETs.

For example, "P-Channel Germanium FinFET based on Rapid Melt Growth", IEEE Electron Device Letters, Vo1.28, No.7, July 2007, pp 637-639, by Feng J. et al., describes the manufacture of crystalline germanium FinFETs based on the so-called rapid-melt-growth method. The method involves in particular the steps of: (a) depositing amorphous germanium onto silicon substrate; (b) patterning amorphous germanium into fins using lithography and photoresist ashing followed by reactive ion etch; (c) encapsulating the germanium fins by depositing conformal LTO layer (microcrucible); (d) heating up the formed structure via rapid thermal processing (at 940°C) to melt the germanium; (e) cooling down the structure; and (f) removing the LTO microcrucibles by etching with HF. The described method is however characterized by a relatively large number of steps involved, and the formed germanium fins are reported to comprise crystalline defects, in particular at the Ge/Si interface. Moreover, the disclosed germanium fins have a fin width above 130 nm.

Single-crystal germanium pillars with nanowire dimensions as well as GOI structures are disclosed in "Rapid Melt Growth of Germanium Crystals with Self-Aligned Microcrucibles on Si Substrates", Journal of The Electrochemical Society, 152 (8), G688-G693 (2005), by Liu Y. et al. Regarding the Ge pillars, their manufacture involves deposition of a thick amorphous Ge film onto a Si substrate. Then lithography and anisotropic reactive ion etch were used to form Ge pillars. After the resist was stripped, a conformal low-temperature SiO₂ (LTO) layer was deposited to cover the pillars. Regarding the manufacture of GOI structures, an insulator layer was first formed on a Si100 substrate and patterned to open some seeding windows. The insulator layer can be silicon dioxide, silicon nitride, or other materials. Then amorphous Ge was deposited by non-selective deposition on a very thin Si layer previously formed on the insulator layer. Next, the amorphous Ge film was patterned to the desired shapes by photolithography and RIE. Thereafter, a conformal LTO layer was deposited to cover the patterned Ge. The wafers with either pillars or GOI structures were then loaded into a rapid thermal processing RTP chamber and heated up to 940°C to melt the Ge. In both cases, the LTO layer worked as a microcrucible to hold the Ge liquid and prevent it from flowing randomly. The methods disclosed by Liu et al. suffer from several drawbacks among which a rather complex implementation. Also, the disclosed methods are inherently limited by the performance of patterning processes (e.g. photolithography and RIE).

US 6,180,480 discloses a process for making a trench capacitor in a high-aspect ratio trench in a silicon wafer, wherein the process allows completely filling a trench formed in a substrate with a fill material comprising germanium or silicon-germanium. The described method is claimed to be suitable for trenches having widths in the order of 200 nm.

Despite the progress in the art, there is still need for a method of forming high quality mono-crystalline germanium or silicon germanium in a trench having a width narrower than 100nm, wherein the method involves fewer steps than the processes known in the art.

Other advantages of the invention will be immediately apparent to those skilled in the art from the following description.

### Summary of the Invention

According to one aspect of the present invention, it is provided a method of forming mono-crystalline germanium or silicon germanium in a trench provided in a substrate, wherein the method comprises (or consists of) the steps of:
(a) providing a patterned (semiconductor) substrate provided with at least one active region comprising (or consisting of) a semiconductor material and adjacent to two insulating regions;
(b) forming, in the active region, a trench having a width of less than 100 nm in whereby the adjacent insulating regions form the side-walls of the trench and the semiconductor material is exposed at the bottom of the trench;
(c) forming into the trench a fill layer comprising (or consisting of) germanium or silicon-germanium at a temperature of less than (about) 450°C, so as to (substantially) completely fill the trench;
(d) heating the fill layer comprising germanium or silicon-germanium present into the trench at a temperature sufficient to (substantially) completely melt the germanium or silicon-germanium comprising fill layer, whereby none of the adjacent insulating regions or the substrate is melted; and
(e) allowing re-crystallization of the melted fill layer obtained at step (d) thereby forming mono-crystalline germanium or silicon-germanium into the trench.

According to another aspect, the present invention is directed to a method of forming a mono-crystalline germanium or silicon germanium fin structure on a (semiconductor) substrate, wherein the method comprises (or consists of) the steps of:
(a) providing a patterned (semiconductor) substrate provided with at least one active region comprising (or consisting of) a semiconductor material and adjacent to two insulating regions;
(b) forming, in the active region, a trench having a width of less than 100 nm in whereby the adjacent insulating regions form the side-walls of the trench and the semiconductor material is exposed at the bottom of the trench;
(c) forming into the trench a fill layer comprising germanium or silicon-germanium at a temperature of less than (about) 450°C, so as to (substantially) completely fill the trench;
(d) heating the fill layer comprising germanium or silicon-germanium present into the trench at a temperature sufficient to (substantially) completely melt the germanium or silicon-germanium comprising fill layer, whereby none of the adjacent insulating regions or the substrate is melted; and
(e) allowing re-crystallization of the melted fill layer obtained at step (d) thereby forming mono-crystalline germanium or silicon germanium into the trench;
(f) optionally, removing the insulating regions thereby forming a mono-crystalline germanium or silicon-germanium fin structure.

Preferably, in the method of the invention as described above, the at least one trench has a width of less than (about) 80 nm, preferably less than (about) 60 nm, more preferably less than (about) 50 nm, even more preferably less than (about) 30 nm, most preferably of about 20 nm.

Preferably, in the method of the invention as described above, the at least one trench has a (depth-to-width) aspect ratio of more than (about) 2, preferably of more than (about) 5, more preferably of more than (about) 10, even more preferably of more than (about) 20.

Preferably, in the method of the invention as described above, the step of forming a fill layer comprising germanium or silicon-germanium into the trench is performed at a temperature comprised between (about) 100°C and (about) 450°C, preferably between (about) 350°C and (about) 445°C, more preferably between (about) 400°C and (about) 445°C, even more preferably between 420°C and 440°C.

Preferably, in the method of the invention as described above, the step of forming a fill layer comprising germanium or silicon-germanium into the trench is performed by (selective) epitaxial growth.

Preferably, in the method of the invention as described above, the step of forming a fill layer comprising germanium or silicon-germanium is performed by Chemical Vapor Deposition (CVD) technique.

Preferably, in the method of the invention as described above, the step of heating the fill layer comprising germanium is performed at a temperature comprised between (about) 850°C and (about) 950°C, preferably between (about) 900°C and (about) 950°C, more preferably between (about) 920°C and (about) 940°C.

Preferably, in the method of the invention as described above, the step of heating the fill layer comprising silicon-germanium is performed at a temperature comprised between (about) 850°C and (about) 1500°C, preferably between (about) 850°C and (about) 1400°C.

Preferably, in the method of the invention as described above, the duration of the step of heating the fill layer comprising germanium or silicon-germanium is of less than (about) 500 milliseconds, preferably less than (about) 400 milliseconds, more preferably less than (about) 300 milliseconds, even more preferably less than (about) 200 milliseconds, still more preferably less than (about) 100 milliseconds. Preferably still, the duration of the step of heating the fill layer comprising germanium or silicon-germanium is comprised between (about) 1 nanosecond and (about) 100 milliseconds, more preferably between (about) 20 nanoseconds and 100 milliseconds.

Preferably, in the method of the invention as described above, the step of heating the fill layer comprising germanium or silicon-germanium is performed by using laser anneal or flash anneal technique, preferably by laser anneal.

Preferably, in the method of the invention as described above, the step of allowing re-crystallization of the melted fill layer obtained at step (d) is performed by appropriately cooling the melted fill layer.

Preferably, in the method of the invention as described above, re-crystallization of the melted fill layer obtained at step (d) is performed by (selective) epitaxial (re)growth.

Preferably, in the method of the invention as described above, the substrate comprises a semiconductor material which preferably comprises (or consists of) silicon.

Preferably, in the method of the invention as described above, the insulating regions are in the form of a Shallow Trench Isolation (STI) wherein the insulating layer preferably comprises (or consists of) silicon oxide (SiO₂) .

Preferably, the method of the invention, as described above, further comprises the step of:
(g) optionally, loading the patterned substrate provided with at least one active region adjacent to two insulating regions in a process chamber, preferably after step (a) and before step (b) as described above;
(h) optionally, performing a wet cleaning step of the surface of the substrate so as to remove native oxide from the surface of the substrate, preferably before the step of loading the patterned substrate in a process chamber;
(i) optionally performing an in-situ annealing step of the substrate so as to further remove native oxide and contaminants from the surface of the substrate, preferably after the step of loading the patterned substrate in a process chamber and before step (b) as described above.

Preferably, in the method of the invention as described above, the in-situ annealing step before step (b) is performed at temperature of between (about) 800°C and (about) 850°C in H2 ambient.

Preferably, in the method of the invention as described above, the step of removing the insulating regions so as to form a mono-crystalline germanium or silicon germanium fin structure, is performed by suitable etching technique.

According to another aspect, the present invention is directed to the use of a method as described above for the manufacturing of a semiconducting device, preferably a Field Effect Transistor, more preferably a FinFET device.

According to still another aspect, the present invention relates to a FinFET device comprising a germanium or silicon germanium fin structure obtainable by a method as described above.

### Brief Description of the Drawings

All figures/drawings are intended to illustrate some aspects and embodiments of the present invention. Devices are depicted in a simplified way for reason of clarity. Not all alternatives and options are shown and therefore the invention is not limited to the content of the given drawings.

**Figure 1** schematically illustrates one exemplary experimental procedure for carrying out the method of the invention in trenches provided in a STI type of substrate/insulating region system.

**Figure 2** depicts SEM images illustrating the surface migration of germanium out of the trenches at an operating temperature of 600°C while using a method not according to the present invention.

**Figure 3** is a cross-sectional TEM image illustrating twin defects present in germanium grown/deposited in a trench at 430°C.

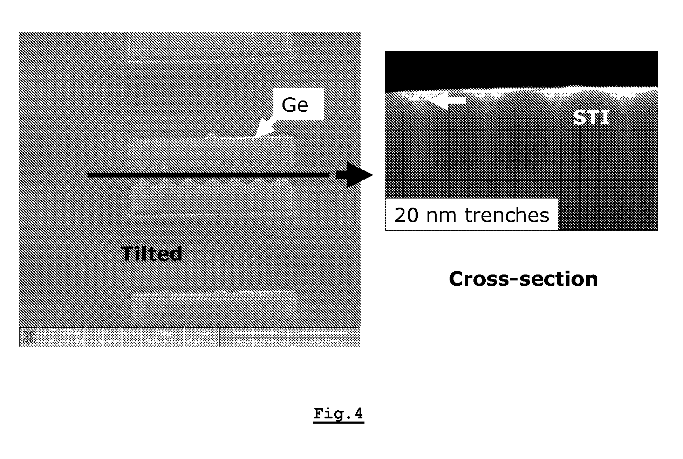

**Figure 4** represents SEM images illustrating germanium growth in trenches having a width of 20 nm, while using a method according to the present invention.

**Figure 5** represents cross-sectional TEM images illustrating twin defects present in germanium heated at 800°C (figure 5a), i.e. while using a method not according to the invention, and showing absence of twin defects in germanium heated at 900°C (figure 5b) while using the method according to the present invention.

### Detailed description of the Invention

According to one aspect of the present invention, it is provided a method of forming mono-crystalline germanium or silicon germanium in a trench provided in a substrate, wherein the method comprises the steps of:
(a) providing a patterned substrate provided with at least one active region comprising a semiconductor material and adjacent to two insulating regions;
(b) forming, in the active region, a trench having a width of less than 100 nm whereby the adjacent insulating regions form the side-walls of the trench and the semiconductor material is exposed at the bottom of the trench;
(c) forming into the trench a fill layer comprising germanium or silicon-germanium at a temperature of less than (about) 450°C, so as to completely fill the trench;
(d) heating the fill layer comprising germanium or silicon-germanium present into the trench at a temperature sufficient to completely melt the germanium or silicon-germanium comprising fill layer; and
(e) allowing re-crystallization of the melted fill layer obtained at step (d) thereby forming mono- crystalline germanium or silicon-germanium into the trench.

According to another aspect, the present invention is directed to a method of forming a mono-crystalline germanium or silicon germanium fin structure on a substrate, wherein the method comprises the steps of:
(a) providing a patterned substrate provided with at least one active region comprising a semiconductor material and adjacent to two insulating regions;
(b) forming, in the active region, a trench having a width of less than 100 nm whereby the adjacent insulating regions form the side-walls of the trench and the semiconductor material is exposed at the bottom of the trench;
(c) forming into the trench a fill layer comprising germanium or silicon-germanium at a temperature of less than (about) 450°C, so as to completely fill the trench;
(d) heating the fill layer comprising germanium or silicon-germanium present into the trench at a temperature sufficient to completely melt the germanium or silicon-germanium comprising fill layer, whereby none of the adjacent insulating regions or the substrate are melted; and
(e) allowing re-crystallization of the melted fill layer obtained at step (d) thereby forming mono- crystalline germanium or silicon-germanium into the trench;
(f) optionally, removing the insulating regions thereby forming a mono-crystalline germanium or silicon- germanium fin structure.

In the context of the present invention, the term "mono-crystalline" is meant to designate single-crystalline form of a material. The terms "trench", "active region" and "insulating region" are herewith meant to have their commonly accepted meaning in the art.

More specifically, an active region or an active area is comprised or formed of a semiconductor material and designates the physical part of a substrate wherein (upon) the corresponding devices (such as e.g. transistors, resistors and capacitors) which perform computing and storage operations are defined. An insulating (isolation) region/area or a field oxide area is comprised or formed of an insulator (dielectric material) and serves to electrically isolate two or more devices on the same substrate. A trench is meant to refer to a recessed area having a rectangular cross-section.

By the expression "the semiconductor material is exposed at the bottom of the trench" it is meant herein that the bottom of the trench is comprised or formed of the semiconductor material.

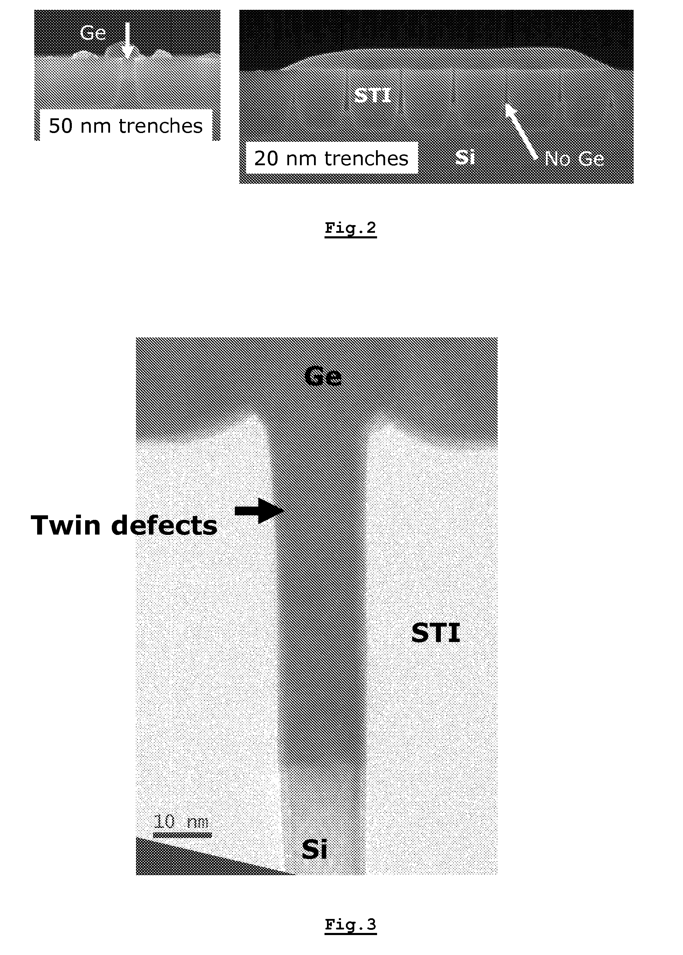

In the context of the present invention, it has been surprisingly discovered that currently available techniques to fill in trenches are not suitable to form high-quality mono-crystalline material (such as e.g. germanium or silicon-germanium) in trenches having high aspect ratio and in particular in trenches having a width of less than 100 nm, more in particular in trenches having a width of less than 50 nm (Fig.2).

It has in particular been discovered that while trying to grow germanium in trenches having a width of less than 100 nm, more in particular in trenches having a width of less than 50 nm, the known techniques are hampered by the poor crystalline quality of germanium when growing in said narrow trenches at low temperature (e.g. of less than about 450°C). More particularly, germanium twin defects occur in the germanium crystals grown into narrow trenches using said method (Fig.3).

Moreover, using the known techniques in narrow trenches at higher growth temperatures (i.e. of higher than about 600°C), the geometry of the trench is further hampering the growth of germanium. In particular, it has been surprisingly discovered that the phenomenon of surface migration at least partly drives the germanium out of the (narrow) trenches. Surprisingly, even no growth at all is observed using known methods in very narrow trenches (i.e. having a width of less than about 20 nm) at higher growth temperatures.

Accordingly, the Applicant has been challenged to develop an improved method to form mono-crystalline germanium (or silicon-germanium) into narrow trenches (i.e. having a width of less than 100 nm, preferably less than less than 80 nm, more preferably less than 60 nm, even more preferably less than 50 nm, yet more preferably less than 30 nm, most preferably of about 20 nm) which would not present the drawbacks of the methods know in the art.

In particular, it was desirable to improve the poor crystalline quality of germanium when growing in narrow trenches at low growth temperature.

In the framework of the present invention, it was also desirable to improve the quality of the filling process with germanium in very narrow trenches at higher growth temperature.

In the context of the present invention, it has been surprisingly discovered that the method according to the invention fully meets the technical requirements as defined above.

The method according to the invention comprises as a first step providing a patterned substrate provided with at least one active region comprising a semiconductor material and adjacent to two insulating regions.

In the context of the method of the invention, any substrate compatible with semiconductor manufacturing may be used. Suitable substrates for use herein may be easily identified by those skilled in the art.

Typically, substrates for use herein include any substrate compatible with semiconductor manufacturing, comprising at least one semiconductor layer a top. Typical examples of suitable substrate for use herein comprise, but are not limited to, bulk semiconductor materials (such as e.g. Si, Ge, SiGe), a silicon on insulator (SOI), germanium on insulator (GeOI), stacked substrates comprising at least a layer of a semiconductor material overlying a support substrate such as quartz, glass, etc.

In a preferred aspect, suitable substrates comprise (bulk) semiconducting material such as e.g. silicon, germanium, silicon-germanium. More preferably, substrates for use herein comprises (or consists of) silicon. Accordingly, in a preferred aspect, the substrate is a silicon wafer.

As indicated above, a substrate for use herein is provided with at least one active region adjacent to two insulating regions. As indicated, the term "insulating region" is meant to have its commonly accepted meaning in the art. Preferably, the term insulating region refers to a dielectric layer (such as e.g. SiO₂) isolating two neighbouring device regions.

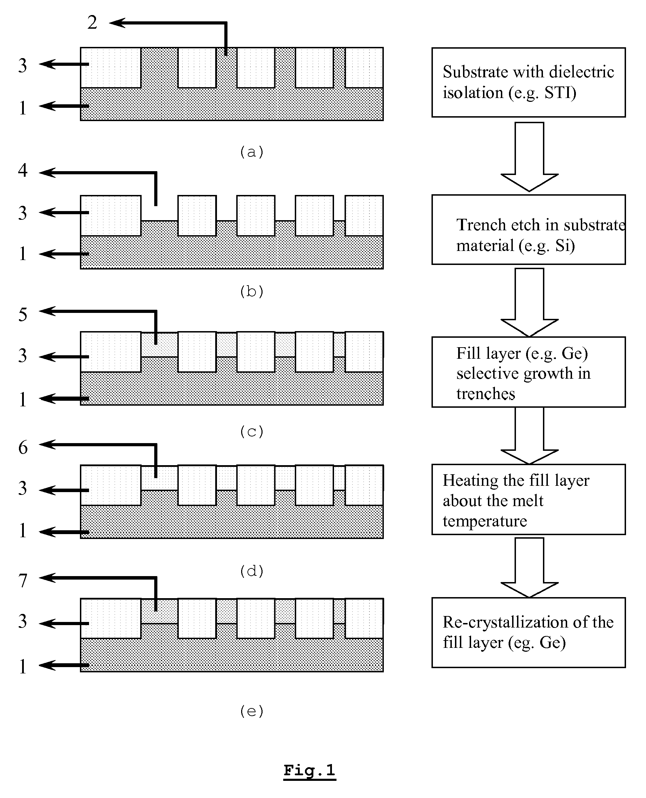

Methods and techniques for providing such a patterned substrate provided with at least one active region comprising a semiconductor material and adjacent to two insulating regions will be easily apparent to those skilled in the art. No further details will be provided hereinafter. **Fig.1(a)** illustrates one exemplary structure showing a patterned substrate **1** provided with at least one active region **2** and several insulating regions **3**.

Suitable materials to form insulating regions for use herein include, but are not limited to, silicon oxide, silicon nitride (Si₃N₄), and mixtures thereof. Preferably, the insulating region consists (substantially) of silicon oxide. Other suitable material will be easily identified by those skilled in the art.

Preferably, the method of the invention further comprises the step of loading the patterned substrate provided with at least one active region adjacent to two insulating regions in a process chamber (or reactor) for further processing. Preferably, this additional step is performed after step (a) as described above and before step (b) of the method as described hereinafter.

Optionally, and before the step of forming a trench (i.e. step (b) of the method) as defined hereinafter, the method of the invention may comprise performing a cleaning step of the surface of the substrate provided or obtained after step (b) of the method.

Preferably, the cleaning step is provided so as to remove native oxide from the surface of the substrate. Suitable ways of removing native oxide from the surface of the substrate will be easily identified by those skilled in the art.

Accordingly, the method of the invention may preferably further comprise the step of performing a wet cleaning step of the surface of the substrate so as to remove native oxide from the surface of the substrate. Preferably, this additional step is performed before the optional step of loading the patterned substrate in a process chamber.

According to preferred aspect of the method of the invention, the cleaning step is performed using a dilute HF dip, preferably using a 2% HF solution. Alternatively, the cleaning step may be performed by in situ cleaning in H₂ ambient.

Optionally, the method of the invention may further comprise the step of performing an in-situ annealing step of the substrate so as to further remove native oxide and contaminants from the surface of the substrate. Preferably, this additional step is performed after the optional step of loading the patterned substrate in a process chamber and before step (b) as described above. Preferably, such optional annealing step is performed at temperature of between (about) 800°C and (about) 850°C.

The method according to the invention comprises as a second step forming, in the active region, a trench having a width of less than 100 nm whereby the adjacent insulating regions form the side-walls of the trench and the semiconductor material is exposed at the bottom of the trench.

Any techniques well know in the art for the formation of trenches may be used in the context of the present invention. Suitable techniques include, but are not limited to, chemical etching, reactive ion etching, chemical vapor phase etching, and combinations thereof. However, the invention is not that limited.

Preferably, in the method of the invention as described above, the at least one trench has a width of less than 80 nm, preferably less than 60 nm, more preferably less than 50 nm, even more preferably less than 30 nm, most preferably of about 20 nm.

Preferably, in the method of the invention as described above, the at least one trench has a (depth-to-width) aspect ratio of more than (about) 2, preferably of more than (about) 5, more preferably of more than (about) 10, even more preferably of more than (about) 20.

According to a very preferred aspect of the method of the invention, the substrate provided with at least one active region (comprising a semiconductor material) adjacent to two insulating regions (corresponding to an insulating region/substrate system) is in the form of a Shallow Trench Isolation (STI) type of substrate system. As STI system/technology is well known in the art, no further details will be provided hereinafter as to its manufacture.

The use of a STI type of insulating region/substrate system has the further advantage that at least one trench is already pre-formed in the active region. However, additional step of removing material so as to free the at least one trench and make it suitable/ready to receive a fill layer (as specified in step (c) of the method of the invention) may be required.

Preferably, the STI type of insulation/substrate system comprises a silicon-comprising patterned substrate (or layer) provided with at least one silicon-comprising active region adjacent to two silicon oxide-comprising insulating regions (or layers). Preferably still, the (patterned) substrate consists (substantially) of silicon, and the insulating regions consist (substantially) of silicon oxide. **Fig.1a** depicts one example of suitable STI-type of insulation/substrate system for use in the method of the invention. However, and as will be apparent to the skilled reader, other types of STI-type of substrate system may be used in the method according to the invention. **Fig.1b** illustrates one example of suitable STI-type of insulation/substrate system provided with at least one suitable trench **4**.

The method according to the present invention involves the additional step of forming into the trench a fill layer comprising germanium or silicon-germanium at a temperature of less than 450°C, so as to (substantially) completely fill the trench.

Suitable techniques to form a fill layer for use in the method of the invention will be easily apparent to those skilled in the art. Preferably, in the method of the invention, the step of forming a fill layer comprising germanium or silicon-germanium is performed by Chemical Vapor Deposition (CVD) technique. Other suitable techniques include, but are not limited to gas phase molecular epitaxy, as well known in the art. More preferably, in the present invention, the step of depositing a fill layer comprising germanium or silicon-germanium is performed by gas-phase chemical vapor deposition technique. Even more preferably, Reduced Pressure Chemical Vapor Deposition (RPCVD) is used.

As will be apparent to those skilled in the art, while performing deposition by CVD technique, the substrate provided with the at least one trench is preferably exposed to one or more (volatile) germanium or silicon-germanium precursors.

Preferred germanium precursors for use in the method of the invention include, but are not limited to, GeH₄, and/or Ge₂H₆ for depositing germanium. However, other germanium precursors of higher orders, such as e.g. Ge₃H₈ and other GeₓH₂ₓ₊₂ related derivatives (such as GeₓHyCl₂ₓ₊₂-y), may be used in the context of the method according to the invention.

While performing the step of forming a fill layer comprising silicon-germanium, precursors such as e.g. combination of GeₓH₂ₓ₊₂ and SiyH₂y₊₂ or GeₓSi₁-ₓH₂ₓ₊₂ may be used in the context of the invention of the method according to the invention.

More preferably, when performing the step of forming a fill layer into the trench, selective deposition technique is used, i.e. only the trench is exposed to e.g. one or more (volatile) germanium or silicon-germanium precursors.

According to a preferred aspect of the method according to the invention, the step of forming a fill layer comprising germanium or silicon-germanium is performed by (selective) epitaxial growth, whereby the fill layer preferably nucleates/grow selectively on the semiconductor substrate at the bottom of the trench and does not nucleate on the insulator material, on the lateral walls of the trench or on the top surface.

Accordingly, this step is typically performed in an epi-reactor, as will be apparent to the skilled person.

Characteristics such as deposition pressure, gas flows, precursor concentrations or partial pressure, atmosphere in the epi-reactor, may be adjusted to tune the process for optimal deposition/forming rate and optimal trench filling.

Preferably, the partial pressure of the precursors is typically comprised between 0.02 Torr and 0.3 Torr. Preferably, CVD is performed at atmospheric pressure (of about 760 Torr) when using Atmospheric Pressure Chemical Vapor Deposition (APCVD), or at lower than atmospheric pressure while using Reduced Pressure Chemical Vapor Deposition (RPCVD). Both CVD techniques may be equally used in the method of the invention.

Preferably still, CVD is performed in H₂ or N₂ ambient. However, other inert gases such as e.g. Ar may be alternatively used.

Preferably, in the method of the invention as described above, the temperature used to form the fill layer into the trench (e.g. the temperature in the epi-reactor chamber) is comprised between (about) 100°C and (about) 450°C, preferably between (about) 350°C and (about) 445°C, more preferably between (about) 400°C and (about) 445°C, even more preferably between 420°C and 440°C.

It is however required that the temperature used to form the fill layer into the trench is of less than (about) 450°C. It has indeed been surprisingly discovered that performing the deposition step at a temperature of less than (about) 450°C prevents or at least reduces germanium or silicon germanium surface migration out of the (narrow) trenches.

The method of the invention may optionally, but preferably, comprise the step of performing a Chemical Mechanical Polishing (CMP) after the deposition step as above-described. This is preferably performed so as to obtain smooth and even substrate surface and/or to remove any excess material present out of the trench.

The method according to the invention further comprises the step of heating the fill layer comprising germanium or silicon-germanium present into the trench at a temperature sufficient to completely melt the germanium or silicon-germanium comprising fill layer, whereby none of the adjacent insulating regions (comprising insulator material) or the (underlying) substrate is melted.

Typically, the heating step will be performed at a temperature close to (preferably equal or above) the melting temperature of germanium or silicon germanium depending on the particular case. Obviously, the heating temperature will be controlled so as to be maintained well below the melting temperature of the substrate used. Accordingly, during the heating step for use in the method of the invention, none of the adjacent insulating regions or the underlying substrate is (even partially) being melted.

Preferably, in the method of the invention as described above, the step of heating the fill layer comprising germanium is performed at a temperature comprised between 850°C and 950°C, preferably between 900°C and 950°C, more preferably between 920°C and 940°C.

Preferably, in the method of the invention as described above, the step of heating the fill layer comprising silicon-germanium is performed at a temperature comprised between 850°C and 1500°C, preferably between 850°C and 1400°C. Typically, the temperature at which the fill layer comprising silicon-germanium is heated will depend upon the germanium concentration of the corresponding silicon-germanium material.

According to a preferred aspect, in the method of the invention as described above, the duration of the step of heating the fill layer comprising germanium or silicon-germanium is of less than 500 milliseconds, preferably is comprised between 1 nanosecond and 100 milliseconds, more preferably between 20 nanoseconds and 100 milliseconds. The heating step may accordingly be characterized as a rapid melting step.

In the context of the present invention, it has been surprisingly discovered that performing the heating step for a duration of less than 500 milliseconds, preferably comprised between 1 nanosecond and 100 milliseconds, more preferably between 20 nanoseconds and 100 milliseconds, may contribute in reducing (or even preventing) phenomenon of surface migration which may drive the germanium or silicon germanium out of the (narrow) trenches.

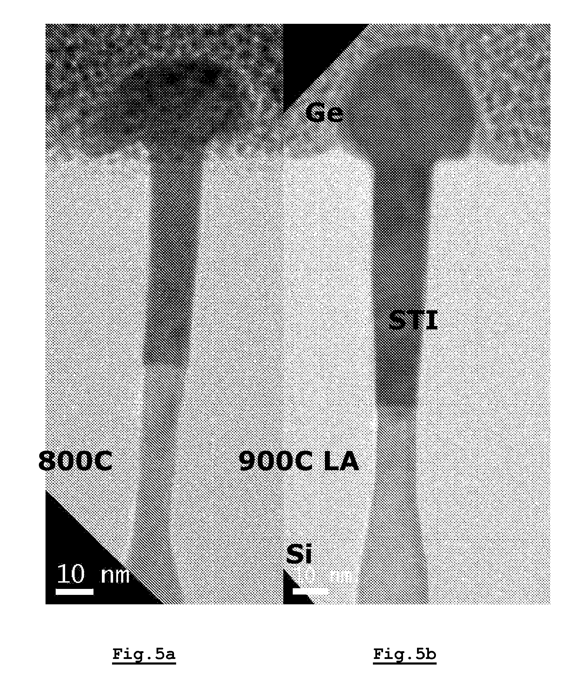

It has been no less surprisingly discovered that said rapid melting step may contribute in reducing (or even preventing) or eliminating any crystalline defects (such as twin defects leading to twinning phenomenon, dislocations) that may be present in the germanium or silicon germanium comprising fill layer contained/grown into the trench after deposition/forming step (c) as above-described (**Fig. 5b**).

According to a very preferred aspect of the method according to the invention, the step of heating the fill layer comprising germanium or silicon-germanium is performed by using laser anneal or flash anneal (flash heating) technique, preferably laser anneal. Laser anneal and flash anneal are techniques well known to those skilled in the art. Alternatively, the step of heating the fill layer comprising germanium or silicon-germanium may be performed by appropriate (flash) microwave anneal/heating.

Preferably, the temperature provided by the laser or the flash heating is comprised between (about) 850°C and (about) 950°C or between 850°C and 1500°C, depending on the particular case as described above. In order to reduce the thermal stress of the laser or flash heating, the laser or flash heating step is preferably performed after reaching a chuck temperature of 250 °C.

Preferably, the heating step is selectively (i.e. locally) applied to the fill layer comprising germanium or silicon-germanium present into the trench. Alternatively, the heating step is non-selective, and both the substrate (and the insulating regions) and the fill layer are subjected to the heating step.

According to the preferred aspect where laser anneal is used, the laser scans the substrate and/or the fill layer at a laser scan speed of preferably (about) 75 mm/s. Alternatively, the laser scan speed can be higher up to 300 mm/s or 450 mm/s.

The method according to the invention further comprises the step of allowing re-crystallization of the melted fill layer obtained after the step (c) as described hereinabove, thereby forming mono-crystalline germanium or silicon germanium into the trench.

Preferably, in the method of the invention as described above, the step of allowing re-crystallization of the melted fill layer is performed by appropriately cooling the melted fill layer obtained in step (c), preferably down to room (chamber or reactor ambient) temperature.

According to a preferred aspect, mono-crystalline germanium or silicon germanium is formed by epitaxial re-crystallization or re-growth.

**Fig.1** illustrates one exemplary experimental procedure for carrying out steps (a) to (e) according to one aspect of the method of the invention in trenches provided in a silicon oxide/silicon STI type of insulating region/substrate system, and wherein: reference **1** designates the (patterned) substrate, **2** designates the at least one active region, **3** designates one insulating region, **4** designates one trench, **5** designates one fill layer comprising germanium or silicon-germanium, **6** designates one melted fill layer, and **7** designates mono-crystalline germanium or silicon-germanium obtained after re-crystallization of one melted fill layer.

The exemplary method starts with the provision of a silicon oxide/silicon STI type of insulating region/substrate system **(****Fig.1a****),** wherein the (patterned) STI substrate comprises at least one active area **2** comprising a semiconductor material surrounded/adjacent with isolation regions **3.** A trench **4** having a width of less than 100 nm is formed in the active area **2**, in such a way that the adjacent insulation regions 3 form the side-walls of the trench and the semiconductor material is exposed at the bottom of the trench **4**. Such a trench is advantageously and appropriately created in-situ in the same reaction/process chamber where the trench filling is preferably performed. According to the embodiment wherein the active areas are made of silicon and the isolation regions of silicon oxide, the trench is created by in-situ vapor HC1 etch in the epitaxial reactor of silicon, selective towards silicon oxide.

Optionally, but advantageously, the method comprises the step of performing a cleaning step of the surface of said substrate so as to remove native oxide from the surface of the substrate before introducing the substrate into the reaction chamber. The cleaning step preferably comprises dipping the substrate into e.g. a diluted HF solution, preferably a 2% HF diluted solution.

Following the cleaning step, the substrate (i.e. the patterned substrate provided with at least one active region comprising a semiconductor material and adjacent to two insulating regions) is loaded into the reaction chamber of an epitaxial apparatus (epi reactor).

Optionally, an in-situ anneal step is then applied to the substrate. The anneal step is performed by injecting a carrier gas in the reaction chamber. Hydrogen may preferably be employed as a carrier gas and the annealing step is preferably performed at a temperature between 800°C and 1000°C. The pressure in the reaction chamber during said first anneal step is preferably about 10 Torr. The in-situ anneal step is performed to remove further native oxide and/or surface contaminants before etching the trench.

Next, after the annealing step has been completed, in situ etching of the semiconductor material is performed in the active region, thereby forming trenches **4** in the semiconductor material having the insulation regions as side-walls. In the particular embodiment wherein a silicon/silicon oxide STI substrate is employed, the trenches **4** have sidewalls constituted of silicon oxide and a bottom constituted of silicon. The etching gas is injected in the reaction chamber. Preferably, said etching gas is HCL vapor, or other chlorine comprising compounds. Advantageously, said etching step does not create any damage to the insulating region (e.g. silicon oxide).

Preferably, the etching step is performed in such a way that the semiconductor material which was previously comprised into the trench **4** is progressively etched to such an extent that the depth the resulting trench (defined by the bottom of the trench) is smaller than the depth defined by the lower level of the adjacent insulating region (e.g. silicon oxide) as depicted in **Fig.1b****.** Alternatively, the depth of the trench 4 is substantially equal to the depth defined by the lower level of the adjacent insulating region.

In any case, the semiconductor material (e.g. silicon) is exposed at the bottom of the trench **4** which incidentally implies that the bottom of the trench is comprised of the semiconductor material used.

Preferably, the etching step is performed at a temperature of said substrate comprised between 800°C and 900°C. The pressure in the reaction chamber is preferably comprised between 10 Torr and 40 Torr. Preferably, during the etching step the HC1 partial pressure is comprised between 0.01 Torr and 0.1 Torr, preferably about 0.04 Torr.

After the etching step, the wafer/substrate is exposed to preferably one or more precursors for selectively depositing germanium or silicon germanium by Chemical Vapor Deposition into the trenches **4**, thereby forming into the trenches a fill layer **5** comprising germanium or silicon germanium.

The CVD (corresponding to step (c) of the method of the invention) is performed at a substrate temperature of less than about 450°C, preferably at about 430°C. Typically, after the deposition/forming step, the trench is (substantially) completely filled with germanium or silicon-germanium material.

Next, after the trench **4** has been completely filled with germanium or silicon-germanium material, a step of heating the fill layer **5** is performed with laser anneal (scan speed at 75 mm/s). The temperature of the laser anneal is selected to be any of 800°C, 850°C, 900°C or 950°C in N₂ ambient, depending on the specific composition of the fill layer. Such temperature shall be, as required in the method of the invention, sufficient to completely melt the germanium or silicon-germanium comprising fill layer, thereby forming a melted fill layer 6.

Advantageously, and before performing the laser anneal the chuck temperature is brought to 250°C and kept constant during the laser anneal.

Once the germanium or silicon-germanium comprising fill layer is completely melted, the melted fill layer **6** is allowed to re-crystallize thereby forming mono-crystalline germanium or silicon-germanium **7** into the trench. Such re-crystallization (or epitaxial re-growth) typically takes place during the temperature ramp-down from the laser anneal temperature to the chuck temperature and then further down to room temperature in N₂ ambient.

TEM measurements performed on the obtained mono-crystalline germanium or silicon-germanium show excellent crystalline quality, and incidentally confirmed absence of any germanium twin defects.

The method according to the present invention allows using the available STI (Shallow Trench Isolation) process technology. In that context, the STI isolation regions have the additional advantage of providing good electrical isolation between the adjacent devices.

Moreover, a method which involves forming germanium or silicon-germanium fins in pre-defined trenches in the substrate instead of forming the fins by patterning of a germanium or silicon-germanium layer atop of a semiconductor substrate has the additional advantage of defect dislocation trapping mechanism known to occur in narrow width (i.e. less than 100nm) trenches, which leads to a better crystalline material.

The method of the invention advantageously allows the integration of different materials (e.g. germanium or silicon-germanium) on a single silicon wafer.

According to another aspect, the present invention is directed to the use of a method as described above for the manufacturing of a semiconducting device. The method of the invention may be used in the manufacturing of well known semiconductor devices, such as e.g. CMOS devices, Buried quantum well devices, MUGFET (multiple gate FET) devices.

However, the method of the invention may find particularly preferred use in the manufacture of Field Effect Transistors, and more preferably for the manufacture of a FinFET device.

More specifically, the method may find a particularly preferred use in the manufacture of fin structures, for use e.g. in the manufacture of FinFET devices.

According to still another aspect, the present invention relates to a FinFET device comprising a germanium or silicon germanium fin structure obtainable by a method as described above.

## Claims

1. A method of forming mono-crystalline germanium or silicon germanium in a trench provided in a substrate, wherein the method comprises the steps of:
(a) providing a patterned substrate provided with at least one active region comprising a semiconductor material and adjacent to two insulating regions;
(b) forming, in the active region, a trench having a width of less than 100 nm whereby the adjacent insulating regions form the side-walls of the trench and the semiconductor material is exposed at the bottom of the trench;
(c) forming into the trench a fill layer comprising germanium or silicon-germanium at a temperature of less than 450°C, so as to completely fill the trench;
(d) heating the fill layer comprising germanium or silicon-germanium present into the trench at a temperature sufficient to completely melt the germanium or silicon-germanium comprising fill layer; and
(e) allowing re-crystallization of the melted fill layer obtained at step (c) thereby forming mono- crystalline germanium or silicon-germanium into the trench.

2. The method according to claim 1 wherein said at least one trench has a width of less than 80 nm, preferably less than 60 nm, more preferably less than 50 nm, even more preferably less than 30 nm, most preferably of about 20 nm.

3. The method according to any of claim 1 or 2, wherein the step of forming a fill layer comprising germanium or silicon-germanium into the trench is performed at a temperature comprised between 100°C and 450°C, preferably between 350°C and 445°C, more preferably between 400°C and 445°C, even more preferably between 420°C and 440°C.

4. The method according to any of the preceding claims, wherein the step of forming a fill layer comprising germanium or silicon-germanium is performed by selective epitaxial growth.

5. The method according to any of the preceding claims, wherein the step of forming a fill layer comprising germanium or silicon-germanium is performed by Chemical Vapor Deposition (CVD) technique.

6. The method according to any of the preceding claims, wherein the step of heating the fill layer comprising germanium is performed at a temperature comprised between 850°C and 950°C, preferably between 900°C and 950°C, more preferably between 920°C and 940°C, and preferably in inert ambient.

7. The method according to any of claims 1 to 5, wherein the step of heating the fill layer comprising silicon-germanium is performed at a temperature comprised between 850°C and 1500°C, and preferably in inert ambient.

8. The method according to any of the preceding claims, wherein the duration of the step of heating the fill layer comprising germanium or silicon-germanium is of less than 500 milliseconds, preferably is comprised between 1 nanosecond and 100 milliseconds, more preferably is comprised between 20 nanoseconds and 100 milliseconds.

9. The method according to any of the preceding claims, wherein the step of heating the fill layer comprising germanium or silicon-germanium is performed by using laser anneal or flash anneal technique, preferably laser anneal.

10. The method according to any of the preceding claims, wherein the step of allowing re-crystallization of the melted fill layer obtained at step (d) is performed by appropriately cooling said melted fill layer.

11. The method according to any of the preceding claims, wherein re-crystallization of the melted fill layer obtained at step (d) is performed by epitaxial (re)growth.

12. The method according to any of the preceding claims, wherein said substrate comprises a semiconductor material which preferably comprises silicon.

13. The method according to any of the preceding claims, wherein the insulating regions are in the form of a Shallow Trench Isolation (STI) wherein the insulating layer preferably comprises silicon oxide (SiO₂) .

14. Use of a method according to any of claims 1 to 13 for the manufacturing of a semiconducting device, preferably a Field Effect Transistor, more preferably a FinFET device.

15. A FinFET device comprising a germanium or silicon germanium fin structure obtainable by a method according to any of claims 1 to 13.
